# EUROPÄISCHE PATENTSCHRIFT

(11) **EP 0 337 304 B1**
(45) Veröffentlichungstag und Bekanntmachung des Hinweises auf die Patenterteilung: **05.01.1994**
(21) Anmeldenummer: 89106118.6
(22) Anmeldetag: 07.04.1989
(51) Int. Cl.: C07F 9/74, H01L 21/365

(54) **Verwendung von Mono oder Diphenylarsinen zur Herstellung von Schicten nach dem Gasphasenepitaxieverfahren**
Use of monophenylarsines or diphenylarsines for the preparation of epitaxial layers in the gas phase
Utilisation de monophénylarsines ou diphenylarsines pour la préparation de couches épitaxiales en phase gazeuse

(30) Priorität: 13.04.1988 DE 3812180
(43) Veröffentlichungstag der Anmeldung: 18.10.1989
(73) Patentinhaber: Preussag Pure Metals GmbH, 38640 Goslar (DE)
(72) Erfinder: Hofmann, Hartmut, Dr., D-3400 Göttingen (DE)
(74) Vertreter: Rücker, Wolfgang

(56) Entgegenhaltungen:
- DE-C- 251 571
- US-A- 4 721 683
- METHODEN DER ORGANISCHEN CHEMIE,Houben Weiyl, Band XIII/8, 1978, Georg Thieme Verlag, Stuttgart, Seiten 34-38
- Fitzer, Fritz "Technische Chemie" ISBN 3-540-06787-6, Springer-Verlag; (1975); Seiten 367-369
- Fluka Katalog 1988/89, Seite 1383

## Beschreibung

Die Erfindung betrifft die Verwendung organischer Arsenverbindungen für die Herstellung von Schichten nach dem Gasphasenepitaxieverfahren, insbesondere bei der Herstellung von Halbleitern.

Bei der Fertigung von Halbleitern und verwandten Elementen ist es wünschenswert und notwendig, gesteuerte Niederschläge aus bestimmten Phosphiden oder Arseniden von dreiwertigen Metallen beispielsweise von Gallium, Indium oder Aluminium zu erzeugen.

In den frühen Tagen der Gasphasenepitaxie erzeugte man III/V Halbleiter unter Verwendung von Arsin, d.h. von Arsenwasserstoff AsH₃, was jedoch Probleme besonderer Art mit sich bringt.

Insbesondere war dieses Verfahren wegen der hohen Giftigkeit des in Gasform vorliegenden Arsenwasserstoffs mit großen Gefahren und Risiken verbunden. Schließlich spielte die Reinheit der Vorratsbehälter für diesen Stoff eine große Rolle und die niedrige Pyrolysegeschwindigkeit bei niedrigen Temperaturen bei dem Epitaxieverfahren aus der Gasphase.

Man versucht daher, den Arsenwasserstoff durch organische Verbindungen zu ersetzen, beispielsweise durch tertiäres Butylarsin (BT₃As) (Appl. Phys. Lett. Vol.50, No.4, 26th January 1987 - US-A-4721683) oder durch Metallalkyle anderer Art die unter Verwendung von Metallhalogeniden und einer Grignardverbindung hergestellt wurden (US-PS 4 611 017, US-PS 4 621 147).

Nachteilig bei der Verwendung von tert. Butylarsin ist dessen Pyrophorie, also die Neigung zur Selbstentzündung, als auch der intensive Geruch.

Aufgabe der vorliegenden Erfindung ist es daher, eine weitere Arsenquelle bereitzustellen, die zur Herstellung von Filmen mit exzellenten Lumineszenzeigenschaften nach dem Epitaxieverfahren geeignet und nicht pyrophor ist.

Gelöst wird diese Aufgabe durch die Verwendung von Mono- oder Diphenylarsinen, erhalten durch intensive Durchmischung von Phenylarsonsäure und hochreinem Zink in Span- oder Plättchenform in Wasser, Reduktion in einem Lösungsmittel unter Kühlung und Zugabe hochreiner Salzsäure, derart, daß nur eine geringe Wasserstoffbildung stattfindet, und Trennung und Trocknung des sich bildenden Phenylarsins unter absolutem Sauerstoff- und Wasserausschluß zur Herstellung von Schichten nach dem Gasphasenepitaxieverfahren.

Mit Hilfe dieser Verbindungen ist es möglich mit metallorganischen Verbindungen der III. Hauptgruppe des Periodensystems - vorzugsweise Triethylgallium (TEG) - Filme mit exzellenten Fotolumineszenz-Eigenschaften bei der Temperatur von 830°K und den V/III-Verhältnissen von bis zu 2,3 aufzuwachsen.

Die Schichten zeigen niedrige Kompensation µ₇₇=2.10⁴cm²/Vs, n₇₇=1 . 10¹⁵cm⁻³ und spiegelnde Oberflächen.

Die Verarbeitung bzw. die Herstellung solcher Epitaxieschichten geschieht nach an sich bekannten Verfahren z.B. in einem Reaktor unter Atmosphärendruck und einem Induktionsheizsystem, um Aufwachstemperaturen zu erreichen.

Die Verarbeitung der erfindungsgemäß zu verwendenden Verbindungen kann auch plasmastimuliert oder photochemischsein oder durch thermische Zersetzung erfolgen.

Das Trägergas wird mit dampfförmigem Phenylarsin beladen. Die Strömungsgeschwindigkeiten und die Temperaturen im Bereich von 700 bis 900 °K werden entsprechend dem Aufwachsverfahrensbedingungen gewählt. Der Wasserstoffstrom streift über das Substrat während der Heizperiode hinweg, wobei die bekannten Vorgänge ablaufen.

Die Darstellung der Phenylarsine erfolgt unter Sauerstoffaufschluß und Sauerstofffreiheit sämtlicher Lösungsmittel und Säuren. Zur Herstellung von PhAsH₂ arbeitet man wie folgt.

78 g (0,39 mol) Phenylarsonsäure werden mit maximal 160 g (2,45 mol) Zink als Späne oder in Plättchenform in einem Kolben mit Rückflußkühler, Rührwerk und Tropftrichter gegeben. Beide Feststoffe werden mit 200 ml Wasser intensiv durchmischt. Dazu werden 200 ml eines donatorfreien Lösungsmittels gegeben, vorzugsweise n-Pentan, so daß auch eine Phasentrennung erfolgen kann. Unter Kühlen bei Raumtemperatur und darunter werden 400 ml konz. Salzsäure so langsam zugetropft, daß eine Wasserstoffentwicklung kaum zu beobachten ist.

Nachdem sämtliche Phenylarsonsäure verbraucht worden ist, wird die organische Phase abgetrennt und die wäßrige Phase mehrfach mit kleinen Portionen Lösungsmittel extrahiert. Die organische Phase sowie alle Extrakte werden vereint und mit einem Trockenmittel wie z.B. Molekularsieb vorgetrocknet. Restliche Wasserspuren können mit einem scharfen Trockenmittel wie z.B. Phosphorpentoxid (P₄O₁₀) entfernt werden. Alle weiteren Operationen werden nun auch unter strengstem Ausschluß von Wasser fortgeführt. Das Lösungsmittel wird durch Destillation vollständig vom Produkt abgetrennt. Zurückbleibendes Phenylarsin kann dann entweder durch Umkondensieren oder durch Destillation unter Vakuum gereinigt werden. Ausbeute: 45 g (45 g entsprechen 76 % der Theorie).

Besonders zu verweisen ist darauf, daß das Reduktionsmittel Zink in hochreinem Zustand vorliegt und Span- oder Plättchenform haben muß.

Die erfindungsgemäß vorgeschlagenen Verbindungen lassen sich auch im MO-VPE oder MO-CVD oder MOMBE Verfahren verwenden.

Das Herstellungsverfahren ist auch ohne Gegenwart von Wasser möglich, indem man die Phenylarsonsäure und das Reduktionsmittel direkt in dem organischen Lösungsmittel suspendiert.

## Patentansprüche

1. Verwendung von Mono- oder Diphenylarsinen, erhalten durch intensive Durchmischung von Phenylarsonsäure und hochreinem Zink in Span- oder Plättchenform in Wasser, Reduktion in einem donatorfreien Lösungsmittel unter Kühlung und Zugabe hochreiner Salzsäure, derart, daß nur eine geringe Wasserstoffbildung stattfindet, und Trennung und Trocknung des sich bildenden Phenylarsins unter absolutem Sauerstoff- und Wasserausschluß zur Herstellung von Schichten nach dem Gasphasenepitaxieverfahren.

## Claims

1. The use of monophenylarsines or diphenylarsines, obtained by intensive thorough mixing of phenylarsonic acid and very pure zinc in chip or platelet form in water, reduction in a donor-free solvent with cooling and addition of very pure hydrochloric acid, in such a manner that only slight formation of hydrogen takes place, and separation and drying of the resulting phenylarsine with the absolute exclusion of oxygen and water, to produce layers according to the gas phase epitaxy process.

## Revendications

1. Utilisation de mono et diphenylarsines, obtenues par mélange intensif d'acide phénylarsonique et de Zinc de haute pureté sous la forme de plaquettes ou de copeaux, réduction sous refroidissement dans un solvant non donneur et addition d'acide chlorhydrique de haute pureté, de telle sorte qu'il n'y ait que formation minime d'eau, séparation et séchage des phénylarsines formées en l'absence totale d'oxygène et d'eau, pour la préparation de couches épitaxiales en phase gazeuse.
